# EUROPEAN PATENT APPLICATION

(11) **EP 1 705 703 A2**
(43) Date of publication of application: **27.09.2006**
(21) Application number: 06251364.3
(22) Date of filing: 15.03.2006
(51) Int. Cl.: H01L 27/01, H01L 21/70, H04M 1/725, H04B 1/40

(54) **Cellular and Wi-Fi communication devices integrated with a thin-film passive-component filter on an insulating substrate**

(30) Priority: 22.03.2005 US 85977
(71) Applicant: SYCHIP INC., Plano, Texas 75093 (US)
(72) Inventor: Degani, Yinon, Highland Park, NJ 08904 (US); Fan, Yu, Dallas, TX 75252 (US); Gao, Charley Chunlei, Plano, TX 75024 (US); Sun, Kunquan, Plano, TX 75093 (US); Sun, Liguo, Plano, TX 75093 (US); Tai, King Lien, Berkeley Heights, NJ 07922 (US)
(74) Representative: Williams, David John

(57) **Abstract**

The specification describes an integrated passive device (IPD) designed to allow implementation of cellular RF and Wi-Fi RF in a single hand held device. To address the problem of RF interference a thin film RF high rejection bandpass filter (39) is formed in an IPD implementation by forming thin-film passive components, e.g. a thin-film capacitor and a thin-film inductor, on an insulating substrate. The IPD implementation preferably uses silicon as the substrate material. This allows the thin film RF high rejection bandpass filter to be made using silicon processing technology, and thus produce low cost filters that still meet stringent performance requirements demanded due to the co-existing RF units. In preferred embodiments of the invention, wafer level processing using silicon substrates adds to the cost effective manufacture of the highly functional IPDs.

## Description

### Field of the Invention

This invention relates to mobile communications devices that contain both cellular and Wi-Fi functionality.

### Background of the Invention

(Portions of the technical material contained in this section may not be prior art.)

Cellular phones interact with a wireless network, and contain a radio frequency (RF) transceiver and antenna to implement that interaction. The RF circuits are designed to operate on carrier frequencies assigned by regulatory authorities. Accordingly, cellular phones are equipped with RF filter devices to restrict RF operation to the assigned bands.

Advances in mobile communications technology have created a new demand for cellular phones that have Wi-Fi capability. To implement this requires two RF units within a single hand held device. When the two RF units are operated simultaneously, a conflict arises between RF signals interacting with the wireless network and signals for the Wi-Fi unit.

The cellular phone market continues to demand smaller hand held devices. Thus miniaturization of RF circuits is an important goal of RF technology. Of particular concern are the passive devices in the RF circuits. State of the art radio frequency (RF) electrical circuits use large quantities of passive devices. When new Wi-Fi RF circuits are added to implement the new service features, the problem of miniaturization becomes even more challenging.

Significant advances in miniaturization have been achieved. In may cases these involve surface mount technology (SMT). Small substrates containing large numbers of passive components are routinely produced using surface mount technology.

More recent advances involve integrated passive devices (IPDs) where some of the RF components are built on a single platform. See for example United States Patent Application Serial Number 10/835,338, which describes and claims IPD devices with very efficient integration. This application is incorporated herein in its entirety. In spite of advances in IPD technology, RF devices continue to use a hybrid integration circuit approach where IC chips, IPDs, and discrete RF components are individually assembled to produce the RF unit.

### Summary of the Invention

We have designed IPDs for RF devices that allow simultaneous operation of cellular RF and Wi-Fi RF units in a single hand held device. To address the problem of RF interference a thin film RF high rejection bandpass filter is formed in an IPD implementation. The IPD preferably uses silicon as the substrate material. This allows the thin film RF high rejection bandpass filter to be made using silicon processing technology, and thus produce low cost filters that still meet the stringent performance requirements demanded of the cellphone due to the co-existing RF units. In preferred embodiments of the invention, wafer level processing using silicon substrate adds to the cost effective manufacture of these highly functional IPDs.

### Brief Description of the Drawing

Fig. 1 is a schematic representation of a generic IPD showing the three main types of circuit components integrated on a single substrate; and
Fig. 2 is a circuit diagram for a high rejection RF bandpass filter;
Fig. 3 is a layout design for the circuit of Fig. 2.

### Detailed Description

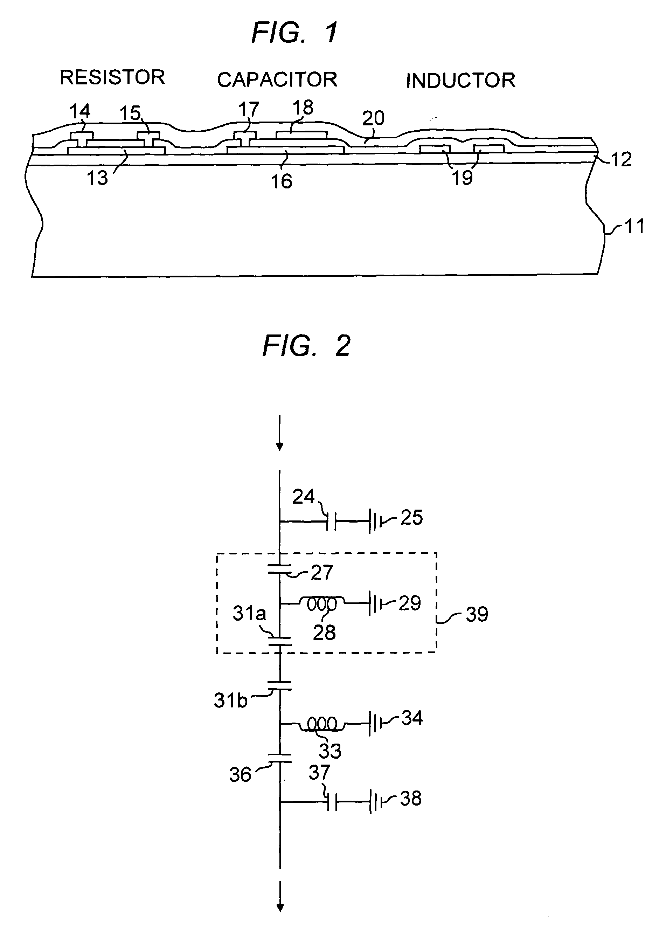

Fig. 1 shows the three major passive components integrated on a single substrate 11. The substrate 11 may be any insulating substrate, but, for reasons that will be described below, is preferably silicon or polysilicon. A significant advantage of IPD technology is that the IPD can be manufactured at the wafer level. This is considerably more efficient and cost effective than the conventional approach of assembling many passive components on a printed circuit board (PCB). However, wafer level manufacture for IPDs is a relatively recent development. This is partly due to the fact that passive devices are relatively large, and have inherent limitations on the degree to which they can be minimized. Therefore, whereas using wafer level fabrication of integrated passive device circuits may not be attractive commercially using 3" or 4" silicon wafers, the arrival in the commercial arena of 8" or 12" silicon wafers makes wafer level manufacture of IPDs not only viable, but commercially attractive. A key to the success of this new technology is the use of silicon as the IPD substrate material.

Recognizing that the silicon in the IPD implementation of the invention is passive, i.e. it does not contain active transistor elements as in a conventional silicon integrated circuit, a variety of new choices are available for the substrate material. One of these is to use a so-called junk wafer. In a wafer production facility, after sawing and polishing the wafers, each wafer is subjected to quality control, where the wafer is measured for conformity to rigid standards for physical size and electrical properties. Typically wafers with chips or scratches will be rejected. Wafers that have excessive or non-uniform conductivity are also rejected. In many cases the rejected wafers are scrapped, and sometimes referred to as "junk wafers". In this description, a "refuse" wafer includes wafers that are cut from a boule, measured by one or more physical or electrical tests, and rejected for failing a test. Refuse wafers have relatively low commercial value. A refuse wafer may be expected to have a value of less than 50%, and more typically, less than 10%, of the value of an acceptable wafer. To obtain a relatively high resistivity surface for the IPD, a thick silicon dioxide layer, or other suitable insulating layer, may be formed on the silicon wafer surface.

Another option for the silicon substrate is to use a polysilicon substrate. The polysilicon may be deposited on another wafer, e.g. a refuse wafer, as described in the patent application referenced above. Polysilicon can have relatively high resistivity, a property desired for the IPD substrate. Polysilicon is characterized by a grain structure, wherein the layer or body is comprised of many grains of silicon, separated by grain boundaries. The grain boundaries behave electrically as recombination centers, drastically reducing the lifetime of free carriers in the body. In terms of electrical behavior, this characteristic separates polysilicon from single crystal silicon. While single crystal silicon is a semiconductor, the large number of grain boundaries in polysilicon make it, in an undoped or intrinsic state, an insulator. The resistivity of polysilicon is a partly a function of the number of grain boundaries, or the fineness of the grain structure. Thus very fine grain polysilicon may have very high resistivity. Polysilicon may easily be produced with a resistivity of more than 10 KOhm-cm. In the context of the invention, resistivity values of more than 0.1 KOhm-cm, and preferably more than 1 KOhm-cm are desired. The polysilicon may be a layer produced, for example, by CVD (as described in the referenced application). Other approaches may be found useful. For example, methods are known for e-beam evaporation of polysilicon. Any suitable alternative for forming a thick, wide area, low resistivity, polysilicon substrate or substrate layer is suitable for these embodiments of the invention. In processing the polysilicon wafer for an IPD substrate, it is preferred that a layer of silicon dioxide be grown or deposited on the surface of the polysilicon wafer.

Yet another option is to use conventional single crystal silicon wafers. In this case also, a thick layer of silicon dioxide is first grown or deposited on the surface of the substrate. Advances in silicon technology show promise of single crystal wafers that have inherently high resistivity. These may be especially suitable as substrates for IPDs.

In this description, the use of the term silicon as an IPD substrate material should be interpreted as generic to all of the options just described.

Although silicon wafers are physically thin (e.g. 200-500 microns), they are relatively robust physically, and can be handled and processed. They are very flat over a large area, and typically have a highly polished uniformly smooth surface. And, importantly, they are compatible with silicon wafer fabrication processes and tools.

As mentioned above, the preferred IPD production approach is wafer scale fabrication. In this approach, a large number of finished, or nearly finished, devices are produced on the silicon wafer. After fabrication is essentially complete, the wafer is diced into IPD devices. As mentioned earlier, as the size of wafers increases wafer level fabrication becomes more attractive. For example, a twelve-inch wafer is capable of providing more than 500 device sites. Each site is approximately a centimeter square, easily large enough to accommodate an IPD.

The effectiveness of wafer scale fabrication can be multiplied using thin film fabrication approaches for forming the passive devices. A common prior art approach, even at the wafer level, is to mount and attach discrete passive elements to the wafer substrate. Typically this is done using surface mount technology (SMT). The circuit may be a hybrid circuit having an active portion and a passive portion. However, to implement the IPD of the invention, with an integrated, high performance, high rejection filter, thin-film fabrication techniques are preferred.

Referring again to Fig. 1, integrated passive elements or combinations of interconnected passive elements are generically represented. The substrate 11 is provided with grown oxide layer 12. The resistor comprises resistor body 13, and contacts 14 and 15. The capacitor comprises lower capacitor plate 16, upper capacitor plate 18 and lower capacitor plate contact 17. The inductor comprises spaced apart metal runners 19.

A feature of IPD technology is that elements of more than one component may be formed from the same metal level. For example, resistor contacts 14, 15, and capacitor plate contact 17 may be formed using the same processing steps. Upper capacitor plate 18, and one of the inductor spirals 19 (contacts not shown), may formed using the same steps. The structure is protected with polyimide layer 20.

The thin film passive elements may be formed by a variety of thin film techniques. These techniques are well developed and the specifics need not be reiterated here. See for example U.S. Patent 6,075,691, issued June 13, 2000, and U.S. Patent No. 6,005,197, issued December 21, 1999. The latter patent describes a multi-layer structure for PCBs, which could easily be adapted for the application described here. A convenient way of defining a thin film passive device is a passive device that is formed on a substrate using one or more layers, typically a plurality of layers, deposited on the substrate. In addition, as mentioned above, one or more elements of two or more components may be formed using the same processing steps.

The mobile device of the invention has both cellular radio and Wi-Fi functional capability, and contains both cellular RF and Wi-Fi RF circuits. These circuits are part of the transceiver module. Simultaneous operation of both RF units in the same location imposes an RF compatibility issue between the two circuits. The standard band pass filter, used in conventional cellular phones to limit the transmission band of the carrier frequencies, is not adequate to prevent RF interactions between the cellular RF and the Wi-Fi RF signals. Thus according to one aspect of the invention the band pass filter has unusually high rejection characteristics, and specifications that are more demanding than for the band pass filter in a conventional cellular device. To meet these demands, the use of thin film processing for the filter elements is especially effective.

An example of a suitable filter circuit is shown in Fig. 2. The basic building block in this filter circuit is shown in box 39. It comprises capacitors (C) 27 and 31 a, and inductor (L) 28 connected to ground at 29. In Fig. 2 there are two repeating units shown, the other LC unit comprising capacitors 36 and 31 b, and inductor 33. This LC combination may be used in repeating units to narrow the band pass and increase the out-of-band RF rejection of the filter.

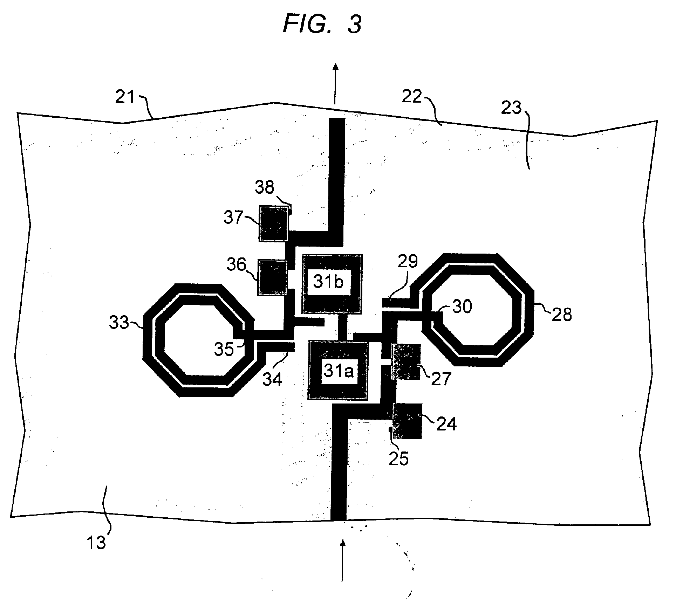

Fig. 3 shows a plan view of the high rejection filter schematically illustrated in Fig. 2. It shows a portion 21 of a larger IPD, as suggested by Fig. 1. Other passive components and units that are part of, for example, the transceiver, may be integrated on other parts of the same IPD. In the embodiment described by Fig. 3, 22 is a ground plane formed at the first level of the thin film fabrication process. Openings in the ground plane are shown in white, at 23 for example. The LC components 24, 27, 28, 31 a, 31 b, and 33 appear in Fig. 3, interconnected as shown in Fig. 2, but physically organized as shown in Fig. 3. Capacitors 31 a and 31 b are electrically equivalent to a single capacitor, which is a suitable alternative to the circuit and layout shown. Via connections from an upper level metal to the ground plane are shown at 25, 29, 34 and 38. Crossovers (or alternatively crossunders) are indicated at 30 and 35. The inductors in Fig. 3 are shown as spirals with two inductor arms (19 in Fig. 1) that are separated by insulating material.

A variety of materials suitable for thin film processing are well known. As an example, aluminum metallization technology for electrodes, interconnections, and inductor spirals, is well developed. Copper is currently widely used for at least one of the metallization levels, typically the last level that inteconnects to the "outside". Newer technologies use copper at all levels. TaSi is a useful thin film resistor body material. Silicon nitride is a useful thin film capacitor dielectric. Polyimide is widely used as the passivating material. For flip-chip bonding of an RF IC chip to the IPD, solder bonding to a suitable under bump metallization is useful. All of these choices are well known, and the techniques for employing them are well developed.

It will be understood that Fig. 3 shows but one suitable layout. Also, the thin film filter of Figs. 2 and 3 is only one of many possible thin film filter designs. The vitalizing aspect shown by Figs. 2 and 3 is the integration of a high rejection band pass filter on an IPD with at least the filter element of the IPD, and preferably the passive components associated with the filter element, comprising thin film devices. As mentioned above, when the LC components of the filter comprise thin film elements, they can be manufactured at relatively low cost to meet demanding specifications and tolerances.

While this description focuses on passive components in the IPD it should be understood that the IPD may carry, in addition to the passive components and the band pass filter, integrated circuit chips with active elements. These may be mounted using any suitable interconnection method, for example, flip-chip bonding or surface mounting. In the usual case these may comprise an RF IC chip, or an RF IC chip and a digital IC chip, e.g. a baseband digital processor.

It will be appreciated that silicon processing tools may be used to produce the IPD. When the metal layers that comprise the passive elements and the interconnections are photodefined, or defined by other suitable thin film techniques that produce precise dimension control of the patterned layers, the electrical characteristics and performance of the resulting devices will be superior to those manufactured using conventional thick film and discrete hybrid technology. Photodefined elements are most typically formed using substractive techniques, i.e. blanket layer deposition followed by selective removal of unwanted portions of the blanket layer. The unwanted portions are typically removed by forming a mask using lithography, and etching the blanket layer using the mask to define the pattern. This approach produces the precision patterns desired for high performance filter elements.

The filter specifications in the following table illustrate the capabilities of the invention in meeting demanding requirements of a high rejection bandpass filter suitable for cellular Wi-Fi combination devices.

**CONVENTIONAL REJECTION FILTER**

| Frequency Band | GSM850 | GSM900 | KPCS1700 | GSM1800 | PCS1900 | UMTS2100 |
|---|---|---|---|---|---|---|
| Rejection (dB) | 48 | 44 | 15 | 12 | 8 | 4 |

**HIGH REJECTION BANDPASS FILTER**

| Frequency Band | GSM850 | GSM900 | KPCS1700 | GSM1800 | PCS1900 | UMTS2100 |
|---|---|---|---|---|---|---|
| Rejection (dB) | 53 | 44 | 43 | 46 | 48 | 41 |

As is evident from these tables, the bandpass filter fabricated for this invention has high rejection in the GSM cellular bands as well as high rejection in the Wi-Fi bands at 1700 and above. A useful specification for the filter of this invention is one that provides at least 30 dB of rejection at at least one frequency band above 1600, and preferably one that provides at least 30 dB of rejection in the KPCS1700 band, the GSM1800 band, the PCS1900 band, and the UMTS2100 band.

As mentioned earlier, an important aspect of the mobile device with combined cellular and Wi-Fi RF circuits is that the two circuits, basically two radios, are designed to be operated at the same time. The mobile device is therefore equipped with switching elements that enable the transceivers of both radios to operate simultaneously.

The mobile device of the invention has been described has having simultaneous cellular radio and Wi-Fi radio transceiver operation. However, the mobile device of the invention may comprise other radio combinations, for example, two cellular radios operating simultaneously on different frequency bands. Thus reference to two or more radios will refer to any combination of two or more RF circuits operating simultaneously in a single mobile device, but at different frequencies.

Additional information about devices made according to the invention may be found at:
http://www.sychip.com/PUB/IPD.pdf
http://www.sychip.com/PUB/WLAN6100EB.pdf
http://www.sychip.com/PUB/WLAN6061 EB.pdf

These are incorporated by reference herein for more details on devices of the invention.

Various additional modifications of this invention will occur to those skilled in the art. All deviations from the specific teachings of this specification that basically rely on the principles and their equivalents through which the art has been advanced are properly considered within the scope of the invention as described and claimed.

## Claims

1. A mobile communications device comprising:
a transceiver adapted for transmitting and receiving simultaneously:
RF signals at a first frequency, and
RF signals at a second frequency,
the transceiver additionally having an RF bandpass filter comprising:
an insulating substrate,
a thin film filter on the substrate.

2. The mobile communications device wherein the thin film filter comprises thin film inductor and thin film capacitor components.

3. The mobile communications device of claim 2 further including, in addition to the thin film filter on the substrate, thin film capacitor components.

4. The mobile communications device of claim 2 including switching elements for activating the transceiver to receive RF signals at the first and second frequencies simultaneously.

5. The mobile communications device of claim 2 wherein the thin film filter comprises at least two metal levels.

6. The mobile communications device of claim 2 wherein elements of at least two different components that comprise the thin film filter are formed from a single metal level.

7. The mobile communications device of claim 1 wherein of at least two different components are formed by common multiple metal layers.

8. The mobile communications device of claim 2 wherein the inductor comprises spiral conductors separated by insulating material.

9. The mobile communications device of claim 1 wherein the bandpass filter has at least 30 dB of rejection at at least one frequency band above 1600.

10. The mobile communications device of claim 9 wherein the bandpass filter provides at least 30 dB of rejection in the KPCS1700 band, the GSM1800 band, the PCS1900 band, and the UMTS2100 band.

11. The mobile communications device of claim 1 wherein the substrate is silicon.

12. The mobile communications device of claim 11 wherein the substrate is polysilicon.

13. The mobile communications device of claim 5 wherein at least one of the metal levels comprises copper.

14. The mobile communications device of claim 5 wherein at least one of the metal levels comprises aluminum.

15. The mobile communications device of claim 1 further including at least one RF IC chip bonded to the substrate.

16. The mobile communications device of claim 15 including at least one digital IC chip.

17. A method for the manufacture of integrated passive devices (IPDs) by steps comprising:
a. providing an insulating wafer substrate, the wafer substrate having a plurality of IPD sites,
b. forming at least one thin film passive device on the IPD sites,
c. forming a thin film filter on the IPD sites, the IPD filter comprising:
at least one thin film capacitor,
at least one thin film inductor.

18. The method of claim 16 wherein the insulating wafer substrate comprises silicon.

19. The method of claim 17 wherein the thin film filter is formed using substractive processing.
